# EUROPÄISCHE PATENTSCHRIFT

(11) **EP 1 767 075 B1**
(45) Veröffentlichungstag und Bekanntmachung des Hinweises auf die Patenterteilung: **18.11.2009**
(21) Anmeldenummer: 05770873.7
(22) Anmeldetag: 06.07.2005
(51) Int. Cl.: H05K 5/00, H05K 5/06, B60R 16/02

(54) **ABDICHTUNG EINES STEUERGERÄTES**
SEALING A CONTROLLER
ETANCHEIFICATION D'UN DISPOSITIF DE COMMANDE

(30) Priorität: 09.07.2004 DE 102004033559
(43) Veröffentlichungstag der Anmeldung: 28.03.2007
(73) Patentinhaber: ZF Friedrichshafen AG, 88038 Friedrichshafen (DE); Continental Automotive GmbH, 30165 Hannover (DE); Walter Söhner GmbH & Co. KG, 74193 Schwaigern (DE)
(72) Erfinder: INGENBLEEK, Robert, 88079 Kressbronn (DE); SCHWAB, Michael, 88677 Markdorf (DE); REMMLINGER, Hubert, 88046 Friedrichshafen (DE); SCHÜTZ, Oskar, 74211 Leingarten (DE); REKOFSKY, Andreas, 93059 Regensburg (DE); RIEPL, Thomas, 93049 Regensburg (DE); SMIRRA, Karl, 83512 Wasserburg (DE); LUGERT, Günter, 93055 Regensburg (DE)
(86) Internationale Anmeldenummer: PCT/EP2005/007272
(87) Internationale Veröffentlichungsnummer: WO 2006/005489

(56) Entgegenhaltungen:
- EP-A- 1 174 237
- DE-A1- 2 617 965
- DE-A1- 10 340 974
- DE-C1- 19 733 237

## Beschreibung

Die Erfindung betrifft ein Gehäuse für ein elektronisches Steuergerät gemäß dem Patentanspruch 1 bzw. 2, die Vervendung des Gehäuses gemäß Patentanspruch 9 sowie ein Verfahren zur Herstellung eines Gehäuses gemäß Patentanspruch 11 bzw.12.

Steuergeräte besitzen meist eine Vielzahl an elektronischen Komponenten, welche in Verbindung mit anderen Komponenten außerhalb des Steuergerätes stehen. Um Steuergeräte gegen Umwelteinflüsse oder mechanische Beanspruchungen zu schützen, werden sie normalerweise in Gehäuse eingesetzt. Damit auch so noch eine Verbindung zu außerhalb des Gehäuses liegenden Komponenten bestehen kann, ist eine elektrische Verbindung von der Gehäuseinnen- zur Gehäuseaußenseite notwendig.

Die EP 0 375 271 B1 beschreibt solch eine elektrische Verbindung. Diese Verbindung wird durch eine Trägerplatte dargestellt, auf welche Leiterbahnen gedruckt sind. Die so hergestellte Platine ist an der Verbindungsstelle zwischen einem Gehäuse und einem Deckel eingelegt und über Formdichtungen mit dem Gehäuse und dem Deckel abgedichtet. Eine elektronische Komponente im Innern des Gehäuses wird über Leitungsdrähte mit den auf die Trägerplatte gedruckten Leiterbahnen verbunden. Auf der Außenseite des Gehäuses sind wiederum Leitungsdrähte an die gedruckten Leiterbahnen gelötet, welche eine Verbindung zu einer außerhalb liegenden Komponente ermöglichen.

Nachteil dieser Anordnung ist, dass die gedruckten Leiterbahnen nicht steckbar sind, dass sie also nicht direkt über eine Steckverbindung mit weiteren Komponenten verbindbar sind. Deswegen sind bei der Verwendung von bedruckten Leiterbahnen viele Schnittstellen notwendig, da die Leiterbahnen auf der Platine über weitere Leitungsdrähte mit den jeweiligen elektrischen Komponenten verbunden werden müssen. Dabei stellt jede Schnittstelle eine potentielle Fehlerquelle dar. Außerdem ist die Herstellung einer gedruckten Leiterbahn auf einer Platine kostenintensiv. Auch die räumliche Anordnung der Schnittstellen kann nur über eine neue Platine verändert werden. Dazu kommt, dass die Verbindung der Platine mit den jeweiligen elektrischen Komponenten über einzelne Leitungsdrähte anfällig auf Vibrationen reagiert.

Die DE 33 15 655 A1 beschreibt eine elektrische Verbindung mittels flexiblen Leiterbahnen. Diese flexiblen Leiterbahnen werden an der Verbindungsstelle zwischen dem Gehäuse und einem Deckel eingelegt und sind wiederum über Formdichtungen mit dem Gehäuse und dem Deckel abgedichtet. Diese flexiblen Leiterbahnen können von der Verbindungsstelle direkt bis an das elektrische Bauteil im Gehäuseinnern geführt werden. Dadurch ist die Anordnung der Komponenten relativ flexibel.

Die Verwendung von flexiblen Leiterbahnen erhöht zwar die Variabilität der Anordnung der elektrischen Komponenten, ist aber ebenso kostenintensiv. Auch diese Verbindung ist nicht steckbar und so ist eine weitere Schnittstelle zu der jeweilig verbundenen elektrischen Komponente notwendig.

Weitere Gehäuse mit mindestens einer elektrischen Verbindung zwischen Gehäuseinnen-und Gehäuse außenseite zeigen die Druckschriften DE 2617965, DE 197 33237 und EP1174237.

Aufgabe der Erfindung ist es nun, ein Gehäuse mit einer elektrischen Verbindung zwischen einer Gehäuseinnen- und einer Gehäuseaußenseite zu ermöglichen, welche kostengünstig ist, eine variable Anpassung der Verbindung von außerhalb des Gehäuses liegenden Komponenten ermöglicht und die Zahl der Schnittstellen möglichst gering hält. Außerdem sollte die Durchführung der elektrischen Verbindung besonders öldicht ausgeführt sein, auch bei hohen Temperaturen. Dies wird erfindungsgemäß mit einer Vorrichtung entsprechend der Hauptansprüche 1 und 2 sowie einem Verfahren entsprechend der Ansprüche 11 und 12 erreicht.

Erfindungsgemäß wird vorgeschlagen, eine elektrische Verbindung zwischen einer Gehäuseinnen- und einer Gehäuseaußenseite fest mit der Gehäusewand zu umspritzen oder zu umpressen. Erfindungsgemäß ist die Gehäusewand dabei doppelwandig ausgeführt und das Dichtmaterial wird in den Zwischenraum gefüllt. Die Gehäusewand besitzt dabei einen Hohlraum, durch welchen die elektrische Verbindung durchgeführt wird. Um eine öldichte Abdichtung auch bei Einsatz unter hohen Temperaturen sicherzustellen, wird in diesen Hohlraum zusätzlich Dichtmaterial eingebracht. Dieses Dichtmaterial umschließt die elektrische Verbindung und dichtet die Durchführung der elektrischen Verbindung durch die Gehäusewand. Das Dichtmaterial übernimmt allerdings noch weitere Funktionen. Zum einen wird die elektrische Verbindung durch die Gehäusewand damit abgedichtet. Zum anderen wird mit dem Dichtmaterial die Abdichtung der Gehäusewand mit dem Deckel und/oder dem Boden ermöglicht weil das Dichtmaterial in Richtung zum Deckel und/oder Boden über die doppelwandige Gehäusewand hinausragt. Das Dichtmaterial kann abhängig von seinen Eigenschaften zusätzlich auch zur Verklebung der Gehäusewand mit dem Deckel und/oder Boden dienen. Besonders vorteilhaft wird für die elektrische Verbindung ein Stanzgitter verwendet. Ein Stanzgitter besteht aus Leiterbahnen, welche vorteilhafter Weise aus einem ebenen, elektrisch leitenden Material gestanzt werden und kann sehr kostengünstig hergestellt werden. Die Leiterbahnen des Stanzgitters sind an sich so steif, dass sie nicht auf weiteres Trägermaterial angewiesen sind. Dieses Stanzgitter kann erfindungsgemäß direkt von der Gehäusewand umspritzt oder umpresst werden.

Das vorteilhafte Stanzgitter kann auf der Gehäuseinnenseite vorteilhafter Weise direkt mit einzelnen Komponenten verbunden werden. Außerdem sind Stanzgitter im Allgemeinen steckbar, was heißt, dass sie direkt als Kontakte in einer Steckverbindung verwendet werden können. So kann das Stanzgitter z. B. auf der Gehäuseaußenseite direkt mit einem Steckverbinder umschlossen sein. Dieser Steckverbinder kann wiederum direkt von der Gehäusewand umspritzt oder umpresst werden. Dadurch wird die Anzahl der Schnittstellen minimiert und es können freie Leiterbahnen vermieden werden. Mit dem Stanzgitter können auf der Gehäuseaußenseite ebenso andere Komponenten wie z. B. Sensoren oder Aktuatoren verbunden werden, welche auch von der Gehäusewand umspritzt oder umpresst werden können.

In einer alternativen Ausführungsform des Gehäuses ist zum Dichten des Deckels und des Bodens gegenüber der doppelwandigen Gehäusewand erfindungsgemäß der Deckel und der Boden mit einem umlaufenden Steg ausgestattet. Diese Stege werden bei der Verbindung der Gehäusewand mit dem Deckel und der Boden in das Dichtmaterial gedrückt und ermöglichen damit eine Abdichtung des Gehäuses.

Das Gehäuse wird erfindungsgemäß so hergestellt, dass in einem ersten Schritt eine elektrische Verbindung, vorteilhafter Weise ein Stanzgitter, in ein Spritz- oder Presswerkzeug eingelegt wird. Um diese elektrische Verbindung wird dann die Gehäusewand gespritzt oder gepresst. Die Gehäusewand besitzt dabei einen Hohlraum, durch den die elektrische Verbindung geführt wird. Die Gehäusewand ist doppelwandig ausgeführt. In einem weiteren Schritt wird dann das Dichtungsmaterial um die elektrische Verbindung, in den Hohlraum der Gehäusewand eingefüllt. Das Dichtungsmaterial kann beispielsweise gespritzt, gegossen, getaucht oder gesprüht werden. Dabei wird auch die Wirkung von Kapillarkräften ermöglicht.

Die Gehäusewand ist mit einem Deckel und/oder einem Boden verbindbar. Diese Verbindung kann konventionell über Schrauben oder Nieten hergestellt werden. Außerdem kann, in Abhängigkeit seiner Eigenschaften, das Dichtmaterial an sich zur Verklebung des Deckels und/oder des Bodens mit der Gehäusewand verwendet werden. Eine weitere vorteilhafte Ausgestaltung sieht eine Schnappverbindung zwischen der Gehäusewand und dem Deckel und/oder dem Boden vor, wobei der Deckel und/oder Boden zusätzlich mit der Gehäusewand verschweißt werden kann. Es ist auch möglich, die Gehäusewand einteilig mit einem Boden oder Deckel auszuführen.

An dem auf der Außenseite des Gehäuses liegendem Ende des Stanzgitters kann beispielsweise auch ein Steckverbinder angebracht sein. Dieser Steckverbinder kann durch das erfindungsgemäße Verfahren zur Herstellung des Gehäuses direkt von der Gehäusewand umspritzt oder umpresst werden. Da die Position der elektrischen Verbindung in der Gehäusewand nicht fest vorgegeben ist, kann die Position der Verbindung besonders einfach variiert werden.

Zusammenfassend wird also ein Gehäuse mit einer elektrischen Verbindung durch eine Gehäusewand vorgeschlagen, welches besonders kostengünstig herstellbar ist und eine besonders variable Anbindung der auf der Innenseite und den auf der Außenseite des Gehäuses liegenden elektronischen Komponenten ermöglicht. Durch die Kombination der Umschließung der elektrischen Verbindung von Gehäuse- und Dichtungsmaterial ist diese Anordnung zudem besonders dicht gegen Öl oder andere aggressive Medien. Dabei ist das erfindungsgemäße Gehäuse auch besonders temperaturfest. Es kann vorteilhafterweise in einem Temperaturbereich von - 40° C bis + 180° C verwendet werden. Zudem dient das erfindungsgemäße Gehäuse natürlich auch als Spanschutz für die eingeschlossenen Elemente.

Zur weiteren Verdeutlichung der Erfindung sowie der Ausführungsformen ist der Beschreibung eine Zeichnung beigefügt. In dieser zeigern:
- Fig. 1: Gehäuse mit überstehendem Dichtmaterial;
- Fig. 2: Gehäuse mit Steg im Deckel und Boden;
- Fig. 3: Gehäuse mit Schnappverschluss;
- Fig. 4: Gehäuse mit Schnappverschluss;
- Fig. 5: Gehäusewand mit integrierter Steckverbindung;
- Fig. 6: Gehäusewand mit integrierter Steckverbindung;
- Fig. 7: Gehäusewand mit integrierter Steckverbindung und
- Fig. 8: Gehäusewand mit integrierter Steckverbindung.

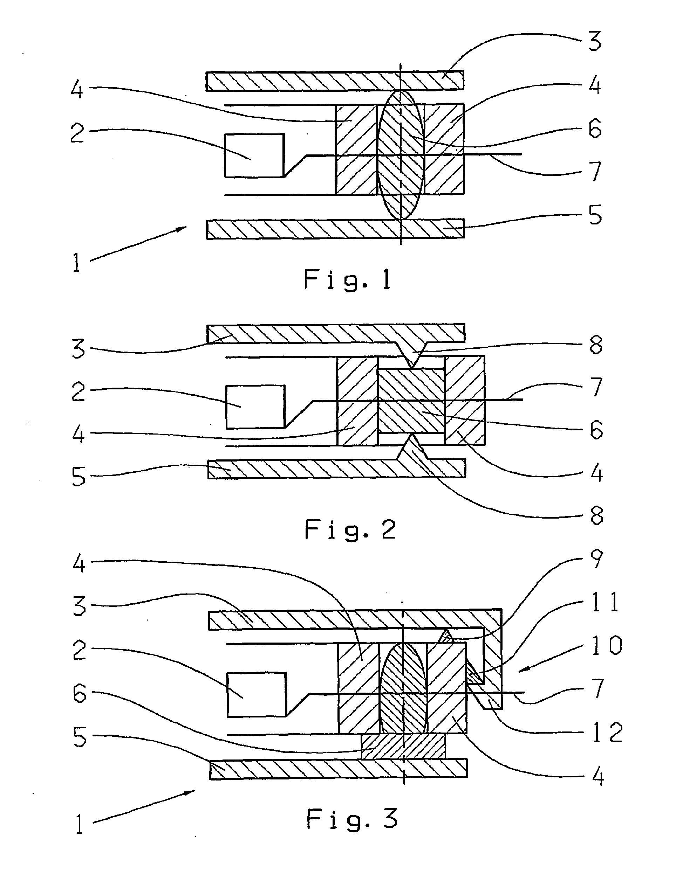

Fig. 1 zeigt ausschnittsweise ein Gehäuse 1 für eine elektronische Vorrichtung 2, mit einem Deckel 3, einer doppelwandigen Gehäusewand 4 und einem Boden 5. In einem Hohlraum der doppelwandigen Gehäusewand 4 ist Dichtmaterial 6 eingebracht. Eine elektrische Verbindung 7 von der Gehäuseinnen- zur Gehäuseaußenseite ist von der doppelwandigen Gehäusewand 4 sowie vom Dichtmaterial 6 dicht umschlossen. Der Deckel 3 und der Boden 5 sind mit der Gehäusewand 4 fest verbindbar. Dies kann z. B. durch eine konventionelle Vernietung, oder auch durch eine Verklebung oder Verschraubung geschehen. Hier wird die Abdichtung durch das Dichtmaterial 6 ermöglicht, welches in Richtung zum Deckel 3 und dem Boden 5 aus der doppelwandigen Gehäusewand 4 herausragt. Bei der Verbindung der Gehäuseteile dichtet das Dichtmaterial 6 den Boden 5 bzw. den Deckel 3 gegen die Gehäusewand 4 ab. Damit kann eine besonders einfache und kostengünstige Abdichtung des Gehäuses 1 erreicht werden. Die elektrische Verbindung 7 ist vorteilhafter Weise ein Stanzgitter. Ein Stanzgitter entspricht elektrischen Leitern, welche direkt aus einem elektrisch leitenden Material gestanzt werden. Die elektronische Vorrichtung 2 kann direkt mit dem Stanzgitter verbunden werden. Dieses Stanzgitter ist dabei so steif, dass es kein weiteres Trägermaterial benötigt und sehr kostengünstig herstellbar ist.

Fig. 2 zeigt eine weitere vorteilhafte Ausgestaltung eines Gehäuses. Die Dichtung 6 ragt hierbei nicht aus der Gehäusewand 4 heraus. Die zusätzliche Dichtfunktion des Dichtmaterials 6 zwischen der Gehäusewand 4 und dem Deckel 3 und dem Boden 5 wird durch einen am Deckel 3 und Boden 5 angebrachten umlaufenden Steg 8 erreicht. Dieser drückt nach der Verbindung von Deckel 3 und Boden 5 mit der Gehäusewand 4 so in das Dichtmaterial 6, dass dieses verformt wird und eine öldichte Abdichtung des Gehäuses gegeben ist.

Fig. 3 zeigt eine weitere Ausgestaltung eines erfindungsgemäßen Gehäuses. Das Dichtmaterial 6 ragt dabei auf der zum Boden 5 hin gerichteten Seite aus der Gehäusewand 4 heraus. Aufgrund seiner Eigenschaften verklebt das Dichtmaterial 6 die Gehäusewand 4 mit dem Boden 5. Der Deckel 3 und die Gehäusewand 4 sind über eine Schnappverbindung 10 verbunden. Die Schnappverbindung 10 besteht aus einer Nase 11 an der Gehäusewand 4 sowie einer korrespondierenden Nase 12 am Deckel 3. Bei dem Zusammenfügen des Deckels 3 und der Gehäusewand 4 schnappt die Nase 12 über die Nase 11 und verbindet somit den Deckel 3 mit der Gehäusewand 4. Dies ist wiederum kostengünstiger als eine konventionelle Verbindung da hier die Verbindungsmittel eingespart werden können. Der Deckel 3 ist mit einer angespritzten Dichtung 9 gegen die Gehäusewand 4 abgedichtet, kann aber auch mit einer eingelegten Formdichtung gegen die Gehäusewand 4 abgedichtet werden. Eine angespritzte Dichtung 9 ist aber kostengünstiger als eine eingelegte Formdichtung.

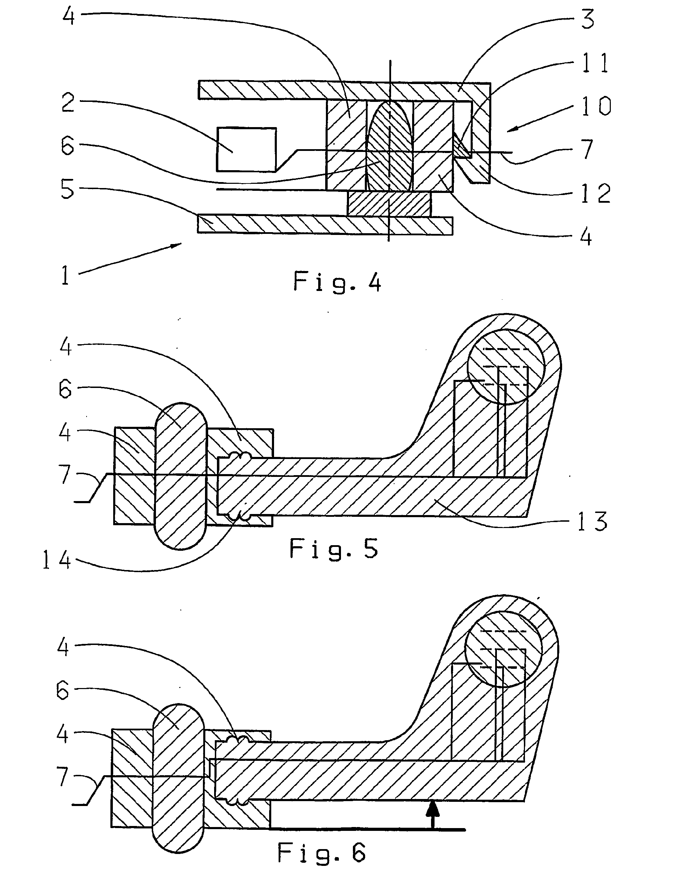

Fig. 4 zeigt ein Gehäuse entsprechend Fig. 3, bis auf die Abdichtung und zusätzlicher Verbindung des Deckels 3 mit der Gehäusewand 4. Hier dient die Schnappverbindung 10 zur Fixierung des Deckels 3 auf der Gehäusewand 4. Der Deckel 3 ist hier direkt mit der Gehäusewand 4 verschweißt oder mit einem zusätzlich aufzubringenden Klebstoff verklebt. Dadurch lässt sich eine zusätzliche Abdichtung einsparen.

Fig. 5 zeigt einen Steckverbinder 13, welcher direkt mit dem Stanzgitter 7 verbunden ist. Der Steckverbinder 13 besitzt an seiner der Gehäusewand 4 zugewandten Seite eine Profilierung 14. Der Steckverbinder 13 ist direkt von der Gehäusewand 4 umspritzt und ist durch seine Profilierung 14 gegen ein Lösen gesichert. Bei solch einer Ausführung sind auf der Gehäuseaußenseite keine offenen Leiterbahnen des Stanzgitters 7 mehr vorhanden; Dies vor allem für Schutz Stanzgitters 7 vor mechanischen Beanspruchung vorteilhaft. Auch andere Module wie Sensoren oder Aktuatoren sind auf diese Weise mit dem Stanzgitter 7 verbindbar und in die Gehäusewand 4 integrierbar.

Fig. 6 zeigt eine Anpassung der Anordnung der Steckverbindung 13 in der Gehäusewand 4. Durch das erfindungsgemäße Verfahren kann die Steckverbindung 13 ohne großen Aufwand in einer veränderten Position angebracht werden, ohne dass ein neues Spritz- oder Presswerkzeug hergestellt werden muss und ohne, dass die Abdichtung angepasst werden muss. Dies ist möglich, da kein exakt vorherbestimmter Ort für die Durchführung der elektrischen Verbindung 7 durch die Gehäusewand 4 notwendig ist. Solange die Steckverbindung 13 von der Gehäusewand 4 umspritzt oder umpresst werden kann, ist eine entsprechende Anordnung möglich. Damit ist besonders einfach und kostengünstig eine Änderung der Anordnung der unterschiedlichen Komponenten, wie z. B. eine Steckverbindung 13, zum Gehäuse 1 möglich.

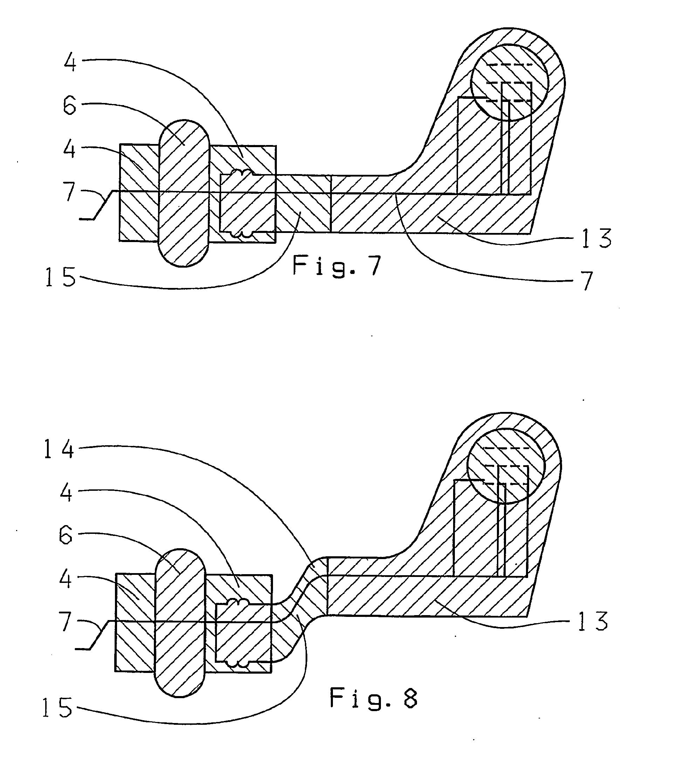

Fig. 7 zeigt eine von der Gehäusewand 4 umspritzte oder umpresste Steckverbindung 13, welche nach dem Spritz- oder Pressprozess verändert werden kann. Dies ist möglich, da ein Teil des Steckverbinders 13 aus einem elastischen Material 15 besteht. Fig. 7 zeigt die Steckverbindung 13 in einer Ausgangsposition, Fig. 8 dieselbe Steckverbindung 13 mit einer vertikal angepassten Position. Natürlich ist diese Variation auch horizontal möglich.

### Bezugszeichen

- 1: Gehäuse
- 2: elektronische Vorrichtung
- 3: Deckel
- 4: Gehäusewand
- 5: Boden
- 6: Dichtmaterial
- 7: elektrische Verbindung
- 8: Steg
- 9: angespritzte Dichtung
- 10: Schnappverbindung
- 11: Nase
- 12: Nase
- 13: Steckverbindung
- 14: Profilierung
- 15: elastisches Material

## Patentansprüche

1. Gehäuse (1) für eine elektronische Vorrichtung (2) aufweisend einen Deckel (3), einen Boden (5) und eine zwischen dem Deckel (3) und dem Boden (5) angeordnete doppelwandige Gehäusewand (4), wobei
• zwischen den beiden Wänden der doppelwandigen Gehäusewand (4) ein Hohlraum ausgebildet ist,
• mindestens eine elektrische Verbindung (7) zwischen Gehäuseinnen-und Gehäuseaußenseite durch die doppelwandige Gehäusewand (4) hindurch derart ausgeführt ist, dass die elektrische Verbindung (7) durch den Hohlraum geführt ist,
• die mindestens eine elektrische Verbindung (7) fest von der doppelwandigen Gehäusewand (4) umspritzt oder umpresst ist,
• der Hohlraum innerhalb der doppelwandigen Gehäusewand (4) mit einem Dichtmaterial (6) zur Abdichtung der Durchführung der mindestens einen elektrischen Verbindung (7) gefüllt ist, und
• zum Dichten des Deckels (3) und/oder des Bodens (5) gegenüber der doppelwandigen Gehäusewand (4) das Dichtmaterial (6) in Richtung zum Deckel (3) und/oder Boden (5) über die doppelwandige Gehäusewand (4) herausragt.

2. Gehäuse (1) für eine elektronische Vorrichtung (2) aufweisend einen Deckel (3), einen Boden (5) und eine zwischen dem Deckel (3) und dem Boden (5) angeordnete doppelwandige Gehäusewand (4), wobei
• zwischen den beiden Wänden der doppelwandigen Gehäusewand (4) ein Hohlraum ausgebildet ist,
• mindestens eine elektrische Verbindung (7) zwischen Gehäuseinnen-und Gehäuseaußenseite durch die doppelwandige Gehäusewand (4) hindurch derart ausgeführt ist, dass die elektrische Verbindung (7) durch den Hohlraum geführt ist,
• die mindestens eine elektrische Verbindung (7) fest von der Gehäusewand (4) umspritzt oder umpresst ist,
• der Hohlraum mit einem Dichtmaterial (6) zur Abdichtung der Durchführung der mindestens einen elektrischen Verbindung (7) gefüllt ist, und
• zum Dichten des Deckels (3) und des Bodens (5) gegenüber der doppelwandigen Gehäusewand (4) der Deckel (3) und der Boden (5) jeweils einen umlaufenden Steg (8) aufweisen, welche nach Verbinden des Deckels (3) und des Bodens (5) mit der Gehäusewand (4) in das Dichtmaterial (6) drücken.

3. Gehäuse (1) nach Anspruch 1, **dadurch gekennzeichnet, dass** die Gehäusewand (4) mit dem Deckel (3) und/oder dem Boden (5) verbindbar ist.

4. Gehäuse (1) nach Anspruch 3. **dadurch gekennzeichnet , dass** die Gehäusewand (4) mit dem Deckel (3) und/oder dem Boden (5) verbindbar ist und das Dichtmaterial (6) zusätzlich als Klebstoff für die Verbindung des Deckels (3) und/oder des Bodens (5) mit der Gehäusewand (4) verwendbar ist.

5. Gehäuse (1) nach einem der vorhergehenden Ansprüche, **dadurch gekennzeichnet, dass** der Deckel (3) und/oder der Boden (5) über einen Schnappverschluss (10) mit der Gehäusewand (4) verbindbar ist.

6. Gehause (1) nach Anspruch 5, **dadurch gekennzeichnet, dass** der Deckel (3) und/oder der Boden (5) mit der Gehäusewand (4) verklebt oder verschweißt ist.

7. Gehäuse (1) nach einem der vorhergehenden Ansprüche, **dadurch gekennzeichnet, dass** die elektrische Verbindung (7) aus einem Stanzgitter besteht.

8. Gehäuse (1) nach Anspruch 7, **dadurch gekennzeichnet. dass** das Stanzgitter (7) an dem auf der Gehäuseaußenseite liegendem Ende mit einem Gehäuse einer Steckverbindung (13) versehen ist, welche direkt von der Gehäusewand (4) umspritzt oder umpresst ist.

9. Verwendung des Gehäuses (1) nach einem der vorhergehenden Ansprüche für eine elektronische Steuerung.

10. Verwendung nach Anspruch 9, **dadurch gekennzeichnet , dass** als elektronische Steuerung eine Getriebesteuerung eines Kraftfahrzeugs vorgesehen ist.

11. Verfahren zur Herstellung eines Gehäuses (1) für eine elektronische Vorrichtung (2), bei welchem Verfahren
• eine elektrische Verbindung (7) in eine Spritz- oder Pressform eingelegt und mit einer doppelwandigen Gehäusewand (4) umspritzt oder umpresst wird,
• ein Dichtmaterial (6) in einen Hohlraum zwischen den beiden Wänden der doppelwandigen Gehäusewand (4), durch den die elektrische Verbindung (7) verläuft, eingefüllt wird, wobei das Dichtmaterial (6) über die doppelwandige Gehäusewand (4) herausragt, und
• die Gehäusewand (4) dann mit einem Deckel (3) und/oder einem Boden (5) verbunden wird, wobei das Dichtmaterial (6) den Deckel (3) und/oder den Boden (5) gegenüber der doppelwandigen Gehäusewand (4) dichtet.

12. Verfahren zur Herstellung eines Gehäuses (1) für eine elektronische Vorrichtung (2), bei welchem Verfahren
• eine elektrische Verbindung (7) in eine Spritz- oder Pressform eingelegt und mit einer doppelwandigen Gehäusewand (4) umspritzt oder umpresst wird,
• ein Dichtmaterial (6) in einen Hohlraum zwischen den beiden Wänden der doppelwandigen Gehäusewand (4), durch den die elektrische Verbindung (7) verläuft, eingefüllt wird, und
• die doppelwandige Gehäusewand (4) mit einem Deckel (3) und einem Boden (5), die jeweils einen umlaufenden Steg (8) aufweisen, verbunden wird, wobei die umlaufenden Stege (8) in das Dichtmaterial (6) drückern.

13. Verfahren nach Anspruch 11, **dadurch gekennzeichnet , dass** an die Gehäusewand (4) zusätzlich eine Dichtlippe (9) angespritzt wird.

14. Verfahren nach einem der Ansprüche 11 bis 13, **dadurch gekennzeichnet, dass** die Gehäusewand (4) mit dem Deckel (3) und/oder dem Boden (5) verschraubt, verklebt, vernietet oder verschweißt wird.

15. Verfahren nach einem der Ansprüche 11 bis 14, **dadurch gekennzeichnet, dass** eine an das Stanzgitter (7) angebrachte Komponente, beispielsweise eine Steckverbindung (13), direkt von der Gehäusewand (4) umspritzt oder umpresst wird.

## Claims

1. Housing (1) for an electronic apparatus (2), having a cover (3), a base (5) and a double-walled housing wall (4) which is arranged between the cover (3) and the base (5), wherein
• a cavity is formed between the two walls of the double-walled housing wall (4),
• at least one electrical connection (7) is established between the housing inner face and the housing outer face through the double-walled housing wall (4) in such a way that the electrical connection (7) is routed through the cavity,
• the at least one electrical connection (7) is encapsulated or surrounded by pressing firmly by the double-walled housing wall (4),
• the cavity within the double-walled housing wall (4) is filled with a sealing material (6) for sealing off the bushing of the at least one electrical connection (7), and
• the sealing material (6) projects beyond the double-walled housing wall (4) in the direction of the cover (3) and/or base (5) in order to seal the cover (3) and/or the base (5) from the double-walled housing wall (4).

2. Housing (1) for an electronic apparatus (2) having a cover (3), a base (5) and a double-walled housing wall (4) which is arranged between the cover (3) and the base (5), wherein
• a cavity is formed between the two walls of the double-walled housing wall (4),
• at least one electrical connection (7) is established between the housing inner face and the housing outer face through the double-walled housing wall (4) in such a way that the electrical connection (7) is routed through the cavity,
• the at least one electrical connection (7) is encapsulated or surrounded by pressing firmly by the housing wall (4),
• the cavity is filled with a sealing material (6) for sealing off the bushing of the at least one electrical connection (7), and
• the cover (3) and the base (5) each have a peripheral web (8) which pushes into the sealing material (6) after the cover (3) and the base (5) are connected to the housing wall (4), in order to seal the cover (3) and the base (5) from the double-walled housing wall (4).

3. Housing (1) according to Claim 1, **characterized in that** the housing wall (4) can be connected to the cover (3) and/or to the base (5).

4. Housing (1) according to Claim 3, **characterized in that** the housing wall (4) can be connected to the cover (3) and/or to the base (5), and the sealing material (6) can additionally be used as an adhesive for connecting the cover (3) and/or the base (5) to the housing wall (4).

5. Housing (1) according to one of the preceding claims, **characterized in that** the cover (3) and/or the base (5) can be connected to the housing wall (4) by means of a snap-action closure (10).

6. Housing (1) according to Claim 5, **characterized in that** the cover (3) and/or the base (5) are/is adhesively bonded or welded to the housing wall (4).

7. Housing (1) according to one of the preceding claims, **characterized in that** the electrical connection (7) comprises a leadframe.

8. Housing (1) according to Claim 7, **characterized in that that** end of the leadframe (7) which is situated on the housing outer face is provided with a housing of a plug-type connection (13) which is encapsulated or surrounded by pressing directly by the housing wall (4) .

9. Use of the housing (1) according to one of the preceding claims for an electronic control means.

10. Use according to Claim 9, **characterized in that** the electronic control means provided is a transmission control means of a motor vehicle.

11. Method for producing a housing (1) for an electronic apparatus (2), in which method
• an electrical connection (7) is inserted into an injection or compression mould and is encapsulated or surrounded by pressing by a double-walled housing wall (4),
• a sealing material (6) is filled into a cavity between the two walls of the double-walled housing wall (4), through which cavity the electrical connection (7) runs, wherein the sealing material (6) projects beyond the double-walled housing wall (4), and
• the housing wall (4) is then connected to a cover (3) and/or a base (5), wherein the sealing material (6) seals the cover (3) and/or the base (5) from the double-walled housing (4).

12. Method for producing a housing (1) for an electronic apparatus (2), in which method
• an electrical connection (7) is inserted into an injection or compression mould and is encapsulated or surrounded by pressing by a double-walled housing wall (4),
• a sealing material (6) is filled into a cavity between the two walls of the double-walled housing wall (4), through which cavity the electrical connection (7) runs, and
• the double-walled housing wall (4) is connected to a cover (3) and a base (5) which each have a peripheral web (8), wherein the peripheral webs (8) push into the sealing material (6).

13. Method according to Claim 11, **characterized in that** a sealing lip (9) is additionally injection-moulded onto the housing wall (4).

14. Method according to one of Claims 11 to 13, **characterized in that** the housing wall (4) is screwed, adhesively bonded, riveted or welded to the cover (3) and/or to the base (5).

15. Method according to one of Claims 11 to 14, **characterized in that** a component, for example a plug-type connection (13), which is mounted on the leadframe (7) is encapsulated or surrounded by pressing directly by the housing wall (4).

## Revendications

1. Boîtier (1) pour un dispositif électronique (2) présentant un couvercle (3), un fond (5) et une paroi de boîtier (4) à double paroi disposée entre le couvercle (3) et le fond (5), dans lequel :
- une cavité est réalisée entre les deux parois de la paroi de boîtier (4) à double paroi,
- au moins une connexion électrique (7) est réalisée entre le côté intérieur du boîtier et le côté extérieur du boîtier à travers la paroi de boîtier (4) à double paroi, de telle sorte que la connexion électrique (7) soit guidée à travers la cavité,
- l'au moins une connexion électrique (7) est recouverte ou revêtue fixement par extrusion par la paroi de boîtier (4) à double paroi,
- la cavité à l'intérieur de la paroi de boîtier (4) à double paroi est remplie d'un matériau d'étanchéité (6) pour étancher le passage de l'au moins une connexion électrique (7), et
- pour l'étanchéité du couvercle (3) et/ou du fond (5) par rapport à la paroi de boîtier (4) à double paroi, le matériau d'étanchéité (6) sort dans la direction du couvercle (3) et/ou du fond (5) au-delà de la paroi de boîtier (4) à double paroi.

2. Boîtier (1) pour un dispositif électronique (2) présentant un couvercle (3), un fond (5) et une paroi de boîtier (4) à double paroi disposée entre le couvercle (3) et le fond (5), dans lequel :
- une cavité est réalisée entre les deux parois de la paroi de boîtier (4) à double paroi,
- au moins une connexion électrique (7) est réalisée entre le côté intérieur du boîtier et le côté extérieur du boîtier à travers la paroi de boîtier (4) à double paroi, de telle sorte que la connexion électrique (7) soit guidée à travers la cavité,
- l'au moins une connexion électrique (7) est recouverte ou revêtue fixement par extrusion par la paroi de boîtier (4),
- la cavité est remplie d'un matériau d'étanchéité (6) pour étancher le passage de l'au moins une connexion électrique (7), et
- pour l'étanchéité du couvercle (3) et du fond (5) par rapport à la paroi de boîtier (4) à double paroi, le couvercle (3) et le fond (5) présentent à chaque fois une nervure périphérique (8) qui presse dans le matériau d'étanchéité (6) après la connexion du couvercle (3) et du fond (5) à la paroi de boîtier (4).

3. Boîtier (1) selon la revendication 1, **caractérisé en ce que** la paroi de boîtier (4) peut être connectée au couvercle (3) et/ou au fond (5).

4. Boîtier (1) selon la revendication 3, **caractérisé en ce que** la paroi de boîtier (4) peut être connectée au couvercle (3) et/ou au fond (5) et le matériau d'étanchéité (6) peut en outre être utilisé comme adhésif pour la connexion du couvercle (3) et/ou du fond (5) à la paroi de boîtier (4).

5. Boîtier (1) selon l'une quelconque des revendications précédentes, **caractérisé en ce que** le couvercle (3) et/ou le fond (5) peuvent être connectés à la paroi de boîtier (4) par le biais d'une fermeture par encliquetage (10).

6. Boîtier (1) selon la revendication 5, **caractérisé en ce que** le couvercle (3) et/ou le fond (5) sont collés ou soudés à la paroi de boîtier (4).

7. Boîtier (1) selon l'une quelconque des revendications précédentes, **caractérisé en ce que** la connexion électrique (7) se compose d'un réseau de barres conductrices.

8. Boîtier (1) selon la revendication 7, **caractérisé en ce que** le réseau de barres conductrices (7) est pourvu, à l'extrémité située sur le côté extérieur du boîtier, d'un boîtier d'une connexion par enfichage (13), qui est recouverte ou revêtue directement par extrusion par la paroi de boîtier (4) .

9. Utilisation du boîtier (1) selon l'une quelconque des revendications précédentes, pour une commande électronique.

10. Utilisation selon la revendication 9, **caractérisée en ce que** l'on prévoit comme commande électronique une commande de boîte de vitesses d'un véhicule automobile.

11. Procédé de fabrication d'un boîtier (1) pour un dispositif électronique (2), dans lequel
- une connexion électrique (7) est introduite dans un moule de pressage ou de pulvérisation et est revêtue ou recouverte par extrusion avec une paroi de boîtier (4) à double paroi,
- un matériau d'étanchéité (6) est versé dans une cavité entre les deux parois de la paroi de boîtier (4) à double paroi à travers lesquelles s'étend la connexion électrique (7), le matériau d'étanchéité (6) sortant hors de la paroi de boîtier (4) à double paroi et
- la paroi de boîtier (4) est alors connectée à un couvercle (3) et/ou un fond (5), le matériau d'étanchéité (6) étanchéifiant le couvercle (3) et/ou le fond (5) vis-à-vis de la paroi de boîtier (4) à double paroi.

12. Procédé de fabrication d'un boîtier (1) pour un dispositif électronique (2), dans lequel :
- une connexion électrique (7) est introduite dans un moule de pressage ou de pulvérisation et est revêtue ou recouverte par extrusion avec une paroi de boîtier (4) à double paroi,
- un matériau d'étanchéité (6) est versé dans une cavité entre les deux parois de la paroi de boîtier (4) à double paroi à travers lesquelles s'étend la connexion électrique (7), et
- la paroi de boîtier (4) à double paroi est alors connectée à un couvercle (3) et un fond (5), qui présentent chacun une nervure périphérique (8), les nervures périphériques (8) pressant dans le matériau d'étanchéité (6).

13. Procédé selon la revendication 11, **caractérisé en ce que** l'on surmoule sur la paroi de boîtier (4) en outre une lèvre d'étanchéité (9).

14. Procédé selon l'une quelconque des revendications 11 à 13, **caractérisé en ce que** la paroi de boîtier (4) est vissée, collée, rivetée ou soudée au couvercle (3) et/ou au fond (5).

15. Procédé selon l'une quelconque des revendications 11 à 14, **caractérisé en ce qu'**un composant monté sur le réseau de barres conductrices (7), par exemple une connexion par enfichage (13), est recouvert ou revêtu directement par extrusion par la paroi de boîtier (4).
